# EUROPEAN PATENT APPLICATION

(11) **EP 4 675 867 A1**
(43) Date of publication of application: **07.01.2026**
(21) Application number: 24929399.4
(22) Date of filing: 06.12.2024
(51) Int. Cl.: H01R 13/66, G06F 1/26

(54) **POWER SUPPLY DEVICE AND COMPUTER SYSTEM**

(30) Priority: 26.03.2024 CN 202410349404
(71) Applicant: Suzhou Metabrain Intelligent Technology Co., Ltd., Suzhou, Jiangsu 215000 (CN)
(72) Inventor: LIU, Yunli, Suzhou, Jiangsu 215000 (CN); SUN, Hui, Suzhou, Jiangsu 215000 (CN)
(74) Representative: Michalski Hüttermann & Partner Patentanwälte mbB
(86) International application number: PCT/CN2024/137493
(87) International publication number: WO 2025/200570

(57) **Abstract**

Embodiments of the present disclosure relate to the technical field of servers, and more particularly, to a power supply device and a computer system. The above-mentioned power supply device includes a first contact and a second contact, wherein the first contact is configured for electrically connecting a conductive interface of a power supply end and the second contact; and the second contact is configured for electrically connecting the conductive interface of the power supply end and a power interface of a server. Herein, a length of the first contact is greater than a length of the second contact, so that, during the insertion of the power supply device into the power supply end, the first contact makes contact with the conductive interface first to raise a voltage of the second contact in advance, and then the second contact starts to connect with the conductive interface to supply power to the server. The above-mentioned power supply device may avoid an electric spark caused by a voltage difference in the instant when the power supply device conducts a circuit with the power supply end, and improve the safety and reliability of the power supply to the server.

## Description

### CROSS-REFERENCE TO RELATED APPLICATION

This application claims the priority of the Chinese Patent application filed on March 26, 2024, before the CNIPA, China National Intellectual Property Administration with the application number of 202410349404.5, and the title of "Power Supply Device and Computer System", which is incorporated herein in its entirety by reference.

### FIELD

The present disclosure relates to the technical field of servers and more particularly, to a power supply device and a computer system.

### BACKGROUND

At present, the power supply mode for the server includes a centralized power supply mode, namely, the power supply module of the server is centralized into a power supply frame body located in the middle area of the cabinet, and enters the power supply frame body via the 220V alternating current. The power supply module inside the power supply frame body converts the 220V alternating current into a low-voltage direct current and then converges same to a copper bar. The server takes power from the copper bar for operation. Generally, a power supply device is connected to the server, and is configured for plugging in the copper bar at a power supply end so as to transmit power to the server.

However, in the process of plugging and unplugging the server and the power supply end, at the moment of contact between the copper bar and the contact of the power supply device, an electric spark may be generated due to a large voltage difference, which will lead to the damage of the metal coating on the surface of the copper bar and the power supply device, increase the contact resistance, and affect the safety and reliability of the power supply end for supplying power to the server. Therefore, the existing server faces issues of insufficient security and reliability.

### SUMMARY

In a first aspect, embodiments of the present disclosure provide a power supply device including a first contact and a second contact, wherein the first contact is configured for electrically connecting a conductive interface of a power supply end and the second contact; and the second contact is configured for electrically connecting the conductive interface of the power supply end and a power interface of a server.

Herein, a length of the first contact is greater than a length of the second contact, during insertion of the power supply device into the power supply end, the first contact makes contact with the conductive interface first to raise a voltage of the second contact in advance, and then the second contact starts to connect with the conductive interface to supply power to the server.

In some embodiments, the first contact is elastically telescoping, and a length of a fully extended first contact is greater than the length of the second contact in atelescoping direction, so that the first contact is in an elastically retracted state after being abutted against the conductive interface during insertion of the power supply device into the power supply end.

In some embodiments, the first contact and the second contact are arranged in parallel in the telescoping direction.

In some embodiments, the power supply device further comprises a current limiting circuit, and the current limiting circuit is connected between the first contact and the second contact.

In some embodiments, the power supply device further comprises a filter energy storage circuit connected to the second contact, the filter energy storage circuit comprises a filter capacitor for storing and filtering a current transmitted to the second contact via the current limiting circuit.

In some embodiments, the power supply device further comprises a bleeder circuit and a logic control circuit;
In some embodiments, the bleeder circuit comprises a bleeder switch, and three ends of the bleeder switch are respectively connected to the second contact, the logic control circuit and a ground end; and the logic control circuit is configured for controlling a switching state of the bleeder switch, and current in the filter capacitor is discharged when the bleeder switch is turned on.

In some embodiments, a length difference of the first contact and the second contact is a quotient of a product of a preset plugging speed of the power supply device and a value of current outputted by the current limiting circuit and a product of a capacitance value of the filter capacitor and a supply voltage value of the server.

In some embodiments, the capacitance value of the filter capacitor ranges from 5,000 µF to 10,000 µF; the supply voltage value of the server is 12 V or 54 V; the preset plugging speed ranges from 0.01 m/s to 0.5 m/s; and the current value outputted by the current limiting circuit ranges from 2 A to 10 A.

In some embodiments, the length difference ranges from 0.01 m to 0.3 m.

In some embodiments, each of the first contact and the second contact comprises a metal plate; and the metal plate of the first contact and the metal plate of the second contact are used for being connected to the conductive interface to enable electrical conduction from the power supply end.

In some embodiments, a load current value of the first contact is less than a load current value of the second contact; and the load current value of the second contact is determined by a power value of the server and a supply voltage value of the server.

In some embodiments, the power supply device further comprises a current transmission circuit, the current transmission circuit is connected between the second contact and the power interface of the server; the current transmission circuit comprises a current detection circuit and a current switching circuit; the power supply device also comprises a logic control circuit.

In some embodiments, the current detection circuit comprises a current detection component, the current detection component is connected to the logic control circuit to detect a current value of the current transmission circuit and transmit the current value to the logic control circuit.

In some embodiments, the current switching circuit comprises a current switching component, the current switching component is connected to the logic control circuit.

In some embodiments, the logic control circuit is configured for controlling a switching state of the current switching component according to the current value of the current transmission circuit to change a current transmission state of the current transmission circuit and the power interface of the server.

In some embodiments, the current switching component comprises a control switch and a field effect transistor; a gate terminal of the field effect transistor is connected to the control switch; and a drain terminal and a source terminal of the field effect transistor are connected to both ends of the current transmission circuit, respectively, to adjust a current flowing state of the current transmission circuit according to a gate voltage generated by the control switch.

In some embodiments, the logic control circuit is further configured for: in response to the current value of the current transmission circuit being greater than a second current threshold that is preset and less than a first current threshold that is preset, reducing the gate voltage generated by the control switch to reduce the current value of the current transmission circuit until the current value of the current transmission circuit is less than a second current threshold; and turning off the control switch to shut off current transmission of the current transmission circuit in response to the current value of the current transmission circuit being greater than the first current threshold;

In some embodiments, wherein the first current threshold is greater than the second current threshold, and the first current threshold and the second current threshold have a multiple relationship with a preset server current threshold.

In some embodiments, the power supply device further comprises a temperature detection circuit for detecting temperature of the current switching component; the temperature detection circuit is connected to the logic control circuit, and the logic control circuit is further configured for, in response to temperature data transmitted by the temperature detection circuit being greater than a preset temperature threshold, turning off the current switching component to shut off the current transmission of the current transmission circuit.

In a second aspect, embodiments of the present disclosure provide a computer system including the power supply end, the server and the power supply device. wherein the power supply device is a power supply device in any one of the embodiments of the first aspect of the present disclosure, and the power supply device is configured for electrically connecting a power supply end and a power interface of a server to supply power to the server.

In some embodiments, the conductive interface of the power supply end is a copper bar for transmitting direct current; the power interface of the server is a power supply interface; and the power supply device is configured for connecting the copper bar and the power supply interface to supply power to the server.

In some embodiments, the system comprises a plurality of power supply devices; and the plurality of power supply devices are configured for connecting the server and the power supply end to form a parallel circuit for supplying power to the server; wherein operating power of the server is greater than the rated power of any one of the plurality of power supply devices; and the total rated power of the plurality of power supply devices is greater than the operating power of the server.

In some embodiments, the plurality of power supply devices comprises a redundant power supply device.

In some embodiments, any two of the plurality of power supply devices have a same size and circuit design.

In some embodiments, the rated current of a current limiting circuit of each of the plurality of power supply devices is proportional to a quantity of the plurality of power supply devices.

In some embodiments, the server comprises a control circuit, and each of the plurality of power supply devices is connected to the control circuit of the server to enable the control circuit of the server to obtain circuit parameters of each of the plurality of power supply devices, wherein the circuit parameters comprise the current value and/or temperature data of the current transmission circuit.

In some embodiments, the control circuit of the server is configured for: in response to current values of the current transmission circuits of all the plurality of power supply devices in the system being greater than a preset current threshold, controlling current switching components of all the plurality of power supply devices to shut off the current transmission.

In some embodiments, the control circuit of the server is configured for: in response to temperature data of all the plurality of power supply devices in the system being higher than a preset temperature threshold, controlling the current switching components of all the plurality of power supply devices to shut off the current transmission.

In a third aspect, embodiments of the present disclosure provide a method of installing a server, the method including:
electrically connecting the power supply device in any one of the embodiments of the first aspect of the present disclosure with a power interface of a server; and
inserting a first contact of the power supply device into a power supply end at a preset speed.

Herein, the preset speed is less than a quotient of a first numerical value and a second numerical value, wherein the first numerical value is a product of a current value outputted by a current limiting circuit and a difference in length of the first contact and the second contact in the telescoping direction, and the second numerical value is a product of a capacitance value of a filter capacitor in a filter energy storage circuit and a supply voltage value of the server.

### BRIEF DESCRIPTION OF THE DRAWINGS

FIG. 1 is a diagram of application environment of a power supply device according to one or more embodiments;
FIG. 2 is a block diagram of a circuit structure of a power supply device, a power supply end, and a server according to one or more embodiments;
FIG. 3 is a structurally schematic diagram of a power device prior to the insertion into a power supply end according to one or more embodiments;
FIG. 4 is a structurally schematic diagram of a power supply device after the insertion into a power supply end according to one or more embodiments;
FIG. 5 is a top view of a conductive interface of a power supply end and a power supply device (partially schematic) according to one or more embodiments;
FIG. 6 is a structural block diagram of a circuit involving a power supply device according to one or more embodiments;
FIG. 7 is a structural block diagram of another circuit involving a power supply device according to one or more embodiments;
FIG. 8 is a structural block diagram of yet another circuit involving a power supply device according to one or more embodiments;
FIG. 9 is a structural block diagram of a computer system according to one or more embodiments;
FIG. 10 is a schematic diagram of a circuit structure in which a plurality of power supply devices are connected to a server according to one or more embodiments; and
FIG. 11 is a structural block diagram of a server according to one or more embodiments.

### DETAILED DESCRIPTION

To provide a clearer understanding of the technical solutions and advantages of the present disclosure, the following detailed description elaborates on the embodiments and related technical content of the present disclosure with reference to the accompanying drawings and textual explanations. It should be understood that the embodiments described below are merely illustrative of the technical aspects of the embodiments of the present disclosure and are not intended to limit the present disclosure to many more possible implementations.

It should be noted that the use of "first", "second", and like relational terms and the like in this document is merely used to distinguish one from another item, state, or action without necessarily indicating or implying a relative importance or sequential relationship. The terms "comprises", "comprising", or any other variation thereof, are intended to cover a non-exclusive inclusion, such that the subject matter recited herein is not limited to the subject matter recited. The term "plurality" or other variants are used to indicate that the quantity of objects is two or more.

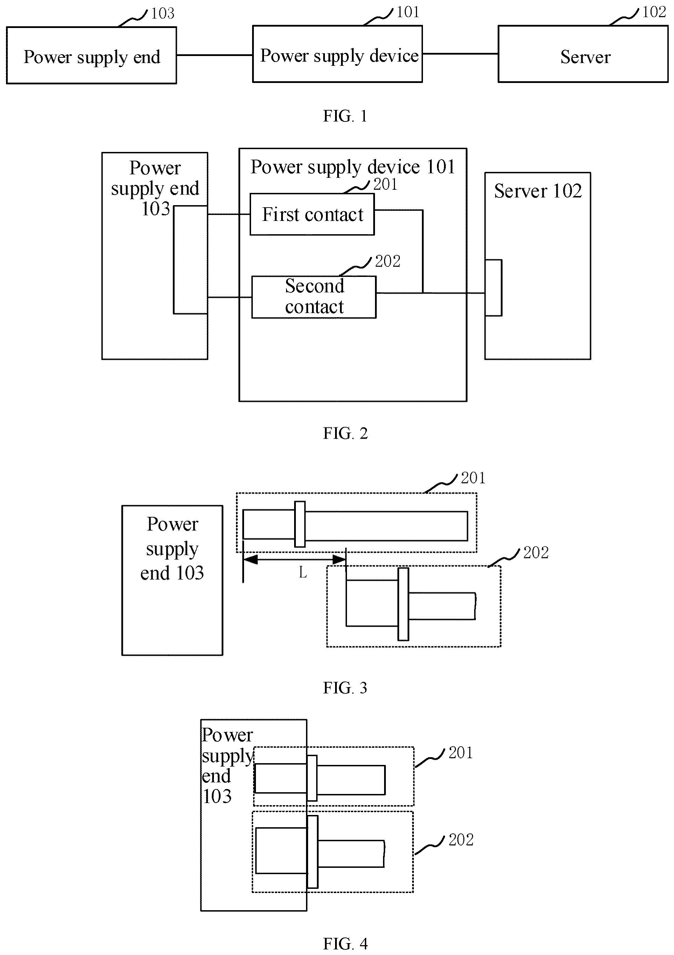

In a first aspect, embodiments of the present disclosure provide a power supply device. The device may be used in an application environment such as that shown in FIG. 1. The application environment may be a centrally powered server rack. The power supply device 101 is electrically connected to the server 102 and the power supply end 103, respectively, to transmit the current of the power supply end 103 into the server 102 to supply power to the server 102.

The server 102 may be realized by an independent server or a server cluster composed of a plurality of servers, and the server 102 may be a server having a PSU (PC power supply device) power interface. In this application environment, the server supplies power in a centralized power supply manner, and the power supply end 103 is configured for converting 220V alternating current into low-voltage direct current. Specifically, a power supply frame body may be provided inside the power supply end 103. After the power supply module inside the power supply frame body converts alternating current into direct current, the direct current is output by a conductive interface of the power supply end 103. Herein, the conductive interface of the power supply end 103 may be a copper bar, and the power supply device 101 is plugged with the copper bar to take power so as to supply power to the server 102.

In some embodiments, referring to FIGs. 1 and 2, the power supply device 101 includes a first contact 201 and a second contact 202. Hereinafter, the first contact 201 and the second contact 202 are described separately.

The first contact 201 is configured for electrically connecting the conductive interface of the power supply end 103 and the second contact 202, and the second contact 202 is configured for electrically connecting the conductive interface of the power supply end 103 and the power interface of the server 102.

Herein, the length of the first contact 201 is greater than the length of the second contact 202, so that during the insertion of the power supply device 101 into the power supply end 103, the first contact 201 first makes contact with the conductive interface to raise the voltage of the second contact 202 in advance, and then the second contact 202 starts to connect with the conductive interface to supply power to the server 102.

In some particular embodiments, the state relationship of the first contact 201 and the second contact 202 with respect to the power supply end 103 is shown in FIG. 3 prior to insertion of the power supply device 101 into the power supply end 103. Before insertion into the power supply device 101, the length of the first contact 201 is greater than the length of the second contact 202, and the length difference is L. After the power supply device 101 is inserted into the power supply device 101, the first contact 201 firstly contacts the conductive interface of the power supply end 103, and the current is firstly supplied into the second contact 202 via the first contact 201 so as to raise the voltage of the second contact 202. Since the power supply device 101 continues to be inserted, the second contact 202 is connected to the conductive interface of the power supply end 103. At this time, the insertion of the power supply device 101 is completed, and the state when the insertion is completed is as shown in FIG. 4. In some cases, when the insertion of the power supply device 101 is completed, the ends of the first contact and the second contact remain flush.

The first contact 201 is configured for continuously increasing the voltage of the second contact 202 from 0 V to the rated voltage value (e. g., 12 V or 54 V) of the power supply end before the second contact 202 is inserted into the power supply end 103.

In some embodiments, the first contact may be elastically telescoping, and the length of the fully extended first contact 201 is greater than the length of the second contact 202 in thetelescoping direction, so that the first contact 201 is in an elastically retracted state after abutting against the conductive interface during the insertion of the power supply device 101 into the power supply end 103.

Specifically, the first contact 201 in FIG. 3 may be in a fully extended state, which begins to be in a compressed state after the first contact 201 makes contact with the conductive interface of the power supply end 103 during the insertion of the power supply device 101 into the power supply end 103, and is continuously compressed as the power supply device 101 continues to be inserted.

By way of example, the end of the first contact 201 facing in the direction of extension may be inelastic, and the end of the first contact 201 facing in the direction of compression may be provided with an elastic member, such as a spring, to be elastically extensible. The first contact 201 may also be an elastically extensible material except for a portion (e. g., a plug-in portion) for inserting the power supply end 103. In particular, how to realize the elastic telescopic movement of the first contact 201 is not so limited here, and a person skilled in the art would have been able to set same according to actual needs.

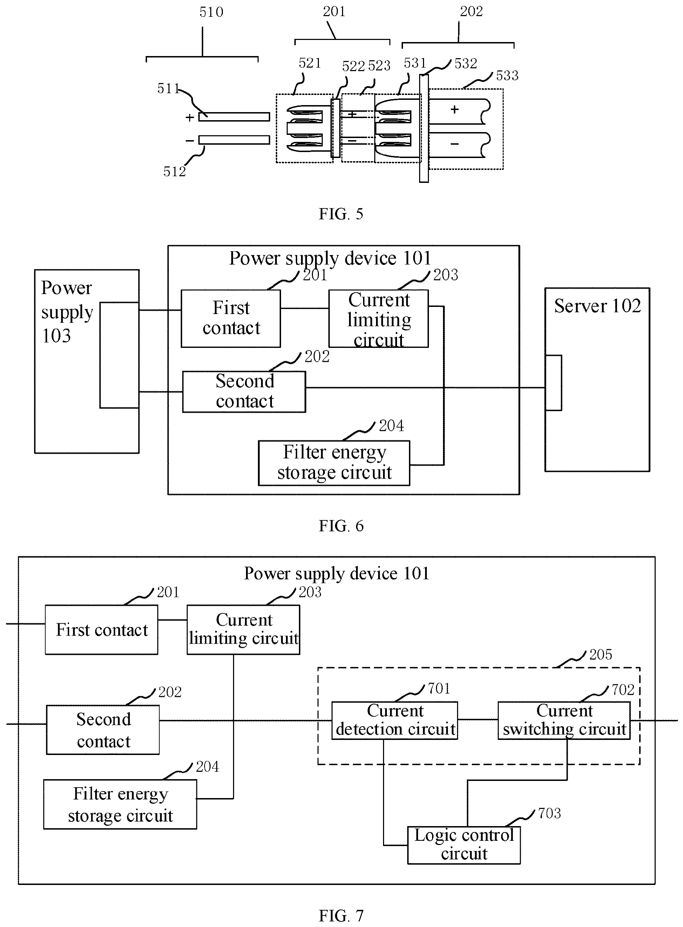

In some specific embodiments, a top-view schematic diagram of the conductive interface 510 of the power supply end 103 and the power supply device 101 (a portion of the power supply device 101 is shown) is shown in FIG. 5. Herein the conductive interface 510 may be a copper bar, respectively including a positive copper bar sheet 511 and a negative copper bar sheet 512, and the first contact 201 and the second contact 202 of the power supply device 101 may be power supply clips having positive and negative poles, respectively. Each of the first contact 201 and the second contact 202 includes an insertion portion (521 and 531) for inserting the conductive interface 510, a limiting portion (522 and 532), and a current lead-out portion (523 and 533). Both the insertion portion 521 and the insertion portion 531 include a metal structure for conducting electricity, such as a copper sheet. The limiting portion 522 and the limiting portion 532 are configured for limiting the depth of the contact inserted into the conductive interface 510. In the direction perpendicular to the direction of insertion of the power supply device into the conductive interface of the power supply end, the outer diameter dimensions of the limiting portion 522 and the limiting portion 532 are both greater than the outer diameter dimension of the edge portion of the conductive interface of the power supply end.

The first contact 201 and the second contact 202 in FIG. 5 are distributed in an up-down configuration in the direction of the top view angle. That is to say, when the power supply device 101 is inserted into the power supply end 103, the first contact 201 is plugged into the lower position of the copper bar of the conductive interface 510, and the second contact 202 is plugged into the upper position of the copper bar of the conductive interface 210. Specifically, the up-down positional relationship between the first contact 201 and the second contact 202 may be changed. Alternatively, the first contact 201 may be plugged into the upper position of the copper bar of the conductive interface 510, and the second contact 202 may be plugged into the lower position of the copper bar of the conductive interface 210.

In the process of inserting the power supply device 101 into the conductive interface 510 of the power supply end 103, the insertion portion 521 of the first contact 201 is inserted into the conductive interface 510 before the second contact 202. The insertion portion 521 abuts against the positive and negative copper bars of the conductive interface 510, and abuts against the edge portion of the conductive interface 510 at the limiting portion 522, and abuts against the edge portion of the conductive interface 510. As the power supply device 101 continues to be inserted into the power supply end 103, the first contact 201 is in a compressed state, the insertion portion 531 of the second contact 202 starts to be inserted into the conductive interface 510, and the insertion portion 531 of the second contact 202 abuts against the positive and negative copper sheets of the conductive interface 510. Subsequently,, the limiting portion 532 of the second contact 202 abuts against the edge portion of the conductive interface 510, and abuts against the edge portion position of the conductive interface 510. When the power supply device 101 is fully inserted into the power supply end 103, the limiting portions of both the first contact 201 and the second contact 202 abut against the edge portion of the conductive interface 510.

In the process of inserting the power supply device 101 into the power supply end 103, the first contact 201 makes contact with the power supply end 103 before the second contact 202. The first contact 201 makes contact with the power supply end 103 and transmits a current to the position of the second contact 202 to raise the voltage of the second contact 202 in advance. As the power supply device continues to be inserted, the voltage value at the position of the second contact 202 approaches to or is equal to the positive electrode voltage value of the power supply end 103. At the moment when the second contact 202 is inserted into the power supply end 103 to conduct a circuit, there is no electric spark caused by a large voltage difference in the moment, which improves the security and reliability of the power supply to the server 102.

At the same time, the power supply device 101 may use a centralized power supply mode to supply power to the server 102, which may improve the power conversion efficiency and also enhance the flexibility of deployment of the server 102 without modifying the interface of the server 102.

In some embodiments, the first contact 201 and the second contact 202 are arranged parallel in the telescoping direction.

The parallel arrangement of the first contact 201 and the second contact 202 may ensure the smooth insertion of the power supply device 101 into the power supply end 103, and improve the user's plug-in experience.

As shown in FIG. 6, in some embodiments, the power supply device further includes a current limiting circuit 203 connected between the first contact 201 and the second contact 202.

Herein, the current limiting circuit 203 may include a current limiting device for restricting the magnitude of the current drawn from the power supply end 103 by the first contact 201. In particular, the current limiting device may be a cement resistor with a relatively high power, or other current limiting devices.

In some specific embodiments, the current value of the current limiting circuit 203 may be in the range of 2A to 3A. Accordingly, a person skilled in the art would have been able to determine the magnitude of the resistance value of the current limiting device according to the current value range and the voltage value of the power supply end. For example, when the voltage at the power supply end is 54V and the current value is 2A, the resistance value of the current limiting device may be 27Ω.

In some embodiments, as shown in FIG. 6, the power supply device 101 also includes a filter energy storage circuit 204 that is electrically connected to the second contact 202.

The filter energy storage circuit 204 may include a filter tank device, such as a filter capacitor, for storing and filtering the current transmitted to the second contact 202 via the current limiting circuit 203. Filter capacitors are commonly used in power rectifier circuits to filter out AC components and to smoothen the DC output. The filter capacitor may be a polar capacitor. The polar capacitor is also called an electrolytic capacitor, which is a capacitor with a polarity, and has a positive and negative polarity.

The first contact 201 is used to input the current into the filter energy storage circuit 204 via the current limiting circuit 203 before the second contact 202 is inserted into the power supply end 103, so as to gradually increase the voltage of the filter energy storage circuit 204 from 0 V to the rated voltage value (for example, 12 V or 54 V) of the power supply end.

In the process of the power supply device 101 being inserted into the power supply end 103, the first contact 201 makes contact with the power supply end 103 before the second contact 202, and the current drawn by the first contact 201 is transmitted to the filter energy storage circuit 204. Due to the function of the current limiting circuit 203, the current value transmitted to the filter energy storage circuit 204 is not too large. This prevents occurrence of electric sparks that could be caused by the instantaneous transmission of current to the filter and energy storage circuit 204 when the first contact 201 is inserted into the power supply end 103.

In some embodiments, as shown in FIG. 7, the power supply device 101 also includes a bleeder circuit (not shown in FIG. 7) and a logic control circuit 703. The bleeder circuit includes a bleeder switch, and three ends of the bleeder switch are respectively connected to the second contact 202, the logic control circuit 703 and a ground end.

The logic control circuit 703 is configured for controlling the switching state of the bleeder switch, and the current in the filter capacitor is discharged when the bleeder switch is turned on.

By adding a bleeder circuit for the filter capacitor in the power supply device 101, it is possible to quickly discharge the signal level in the filter capacitor after the server 102 is unloaded.

In some specific embodiments, the logic control circuit controls the switch-on of the bleeder circuit according to the voltage signal of the first contact 201. In particular, when the voltage of the first contact 201 is detected as zero, the logic control circuit controls the switch-on of the bleeder circuit to discharge the current in the filter capacitor.

In some embodiments, the bleeder switch of the bleeder circuit is controlled by the enable signal of the first contact, and an isolation conversion device is provided between the current limiting circuit 203 and the bleeder circuit and the bleeder switch. When the first contact is in contact with the conductive interface of the power supply end 103, the enable signal of the first contact is at a high level. After passing through the isolation conversion device, the enable signal is converted to a low level, placing the drive of the bleeder switch in a closed state, and the ground end is not connected. When the first contact is separated from the conductive interface of the power supply end 103, the enable signal of the first contact is at a low level, which is converted to a high level by the isolation conversion device. The drive of the bleeder switch controls the bleeder switch to switch on. The bleeder circuit connects the anode of the filter capacitor to the channel of the grounding end. The signal level in the filter capacitor gradually decreases to discharge the current of the filter capacitor.

In some embodiments, the length difference of the first contact 201 and the second contact 202 is a quotient of a product of the preset plugging speed of the power supply device 101 and a value of current outputted by the current limiting circuit 203 and a product of a capacitance value of the filter capacitor and a supply voltage value of the server 102.

Specifically, the length difference is represented by L. The capacitance value of the filter capacitor is represented by C. The supply voltage value of the server 102 is represented by U. The preset plugging speed of the power supply device 101 is represented by V. The current value outputted by the current limiting circuit 203 is represented by I. Accordingly, the length difference of the first contact 201 and the second contact 202 in thetelescoping direction may be represented by the following formula: L=VI/CU.

In some embodiments, the filter capacitor has a capacitance value in the range of 5000 µF to 10000 µF. The server 102 has a supply voltage value of 12V or 54V. The preset plugging speed is in the range of 0.01 m/s to 0.5 m/s. The current value outputted by the current limiting circuit 203 is in the range of 2A to 10A.

Illustratively, the capacitance value of the filter capacitor C = 10000 uf, i. e., 0.01F. The server 102 has a supply voltage value of U = 54V. The current value outputted by the current limiting circuit 203 is 2A. The length difference L is 0.185 m at the preset plugging speed V = 0.05 m/s.

Illustratively, the capacitance value of the filter capacitor C = 10000 uF, i. e., 0.01F. The server 102 has a supply voltage value U = 54V. The current value outputted by the current limiting circuit 203 is 6A. The length difference L is 0.333 m at a preset plugging speed V of 0.03 m/s.

Illustratively, the capacitance value of the filter capacitor C = 5000 uF, i. e., 0.005F. The server 102 has a supply voltage value U = 54V. The current value outputted by the current limiting circuit 203 is 2A. The length difference L is 0.222m at a preset plugging speed V of 0.03m/s.

Illustratively, the capacitance value of the filter capacitor C = 5000 uF, i. e., 0.005F. The server 102 has a supply voltage value U = 54V. The current value outputted by the current limiting circuit 203 is 5A. The length difference L is 0.37 m at a preset plugging speed V of 0.02 m/s.

In some embodiments, the length difference ranges between 0.01 m and 0.30 m.

In some embodiments, each of the first contact 201 and the second contact 202 shown in FIG. 2 includes a metal sheet. The metal sheet of the first contact 201 is used for connecting with a conductive interface. The metal sheet of the second contact 202 is configured for connecting with the conductive interface to realize electrical conduction from the power supply end 103.

In some specific embodiments, the metal sheets of the first contact 201 and the second contact 202 are copper sheets. In some cases, the quantity of copper sheets of the first contact 201 is less than the quantity of copper sheets of the second contact 202. With regard to the specific material and quantity of the metal sheets of the first contact 201 and the second contact 202, a person skilled in the art may be able to arrange them according to actual requirements.

In some embodiments, the load current value of the first contact 201 is less than the load current value of the second contact 202, and the load current value of the second contact 202 is determined by the power value of the server 102 and the supply voltage value of the server 102.

Herein, the load current value refers to the maximum current that may be carried.

In some particular embodiments, the load current value of the first contact 201 may be a rated current value of a component in the filter energy storage circuit 204, and, for example, may be 20 A.

The load current value of the second contact 202 may be the maximum load current value of the server 102, for example, 200 A when the rated power of the server 102 is 2400 W and the rated voltage is 12 V.

In some embodiments, as shown in FIG. 7, the power supply device 101 may also include a current transmission circuit 205 connected between the second contact 202 and the power interface of the server 102.

The current transmission circuit 205 includes a current detection circuit 701, and a current switching circuit 702. The power supply device 101 also includes a logic control circuit 703.

Herein, the current detection circuit 701 includes a current detection component, and the current detection component is connected to the logic control circuit 703 to detect a current value of the current transmission circuit 205 and transmit the current value to the logic control circuit 703.

The current switching circuit 702 includes a current switching component, the current switching component is connected to the logic control circuit 703.

The logic control circuit 703 is configured for controlling the switching state of the current switching component according to the current value of the current transmission circuit 205 to change the current transmission state of the current transmission circuit 205 and the power interface of the server 102.

The current detection component may be a shunt resistor, or a Hall current sensor, or other component for detecting the current.

In some embodiments, the current switching component includes a control switch and a field effect transistor; a gate terminal of the field effect transistor is connected to the control switch; and a drain terminal and a source terminal of the field effect transistor are connected to both ends of the current transmission circuit 205, respectively, to adjust a current flowing state of the current transmission circuit 205 according to a gate voltage generated by the control switch.

Specifically, the field effect transistor may be an N-channel type MOS tube in a MOS tube (MOS, i.e., a Metal-Oxide-Semiconductor Field-Effect Transistor). The control switch may be a charge pump. The output end of the charge pump is connected to the gate terminal of the MOS tube. The conduction state of current at the drain terminal and the source terminal of the MOS tube may be controlled by controlling the output voltage of the charge pump.

In some embodiments, the logic control circuit 703 is further configured for reducing the gate voltage generated by the control switch to reduce the current value of the current transmission circuit until the current value of the current transmission circuit is less than the second current threshold when the current value of the current transmission circuit is greater than the second current threshold and less than the first current threshold.

The logic control circuit 703 is also configured for turning off the control switch to shut off current transmission in the current transmission circuit 205 when the current value of the current transmission circuit is greater than the first current threshold.

Herein, the first current threshold is greater than the second current threshold, and the first current threshold and the second current threshold have a multiple relationship with a preset server current threshold.

The preset server current threshold may be the rated input current of the server 102.

In some embodiments, the first current threshold may be 1.5 times the preset server current threshold and the second current threshold may be 1.1 times, 1.2 times, or 1.3 times the preset server current threshold. In particular, the multiple relationship between the second current threshold and the preset server current threshold may be designed according to the heat dissipation capability of the current transmission circuit 205 and the current-passing capability of the switching component in the current switching circuit 702, and is not particularly limited here.

By means of the current detection component, the magnitude of the current transmitted in the current transmission circuit 205 is monitored. When the current is abnormal (short circuit or over-current fault occurs), the current transmission is turned off by the control switch in the current switching circuit 702, thereby protecting the server 102 and enhancing the security and reliability of the power supply process for the server 102.

In some embodiments, the power supply device 101 also includes a temperature detection circuit for detecting the temperature of the current switching components.

The temperature detection circuit is connected to the logic control circuit 703, which is also used to control the switching state of the current switching component according to the temperature data transmitted by the temperature detection circuit.

In some embodiments, the logic control circuit 703 is also configured for turning off the current switching component to shut off current in the current transmission circuit when the temperature data is greater than the preset temperature threshold.

In particular, the temperature detection circuit may include a thermistor, thermocouple, or other type of temperature sensor. A person skilled in the art will be able to set a preset temperature threshold according to the actual situation of the components of the power board in the power supply device 101. In some specific embodiments, the preset temperature threshold may be set to 105 degrees centigrade.

By feeding back the temperature value of the current switching component detected by the temperature detection circuit to a logic control circuit, when the temperature is greater than a preset temperature threshold, the current switching component is turned off in time to shut off the current transmission. This ensures the circuit is turned off in time in the case where the uneven heat dissipation of the power supply device 101 causes the abnormal heating of the switch device, thereby improving the security of the power supply device 101 for supplying power to the server 102.

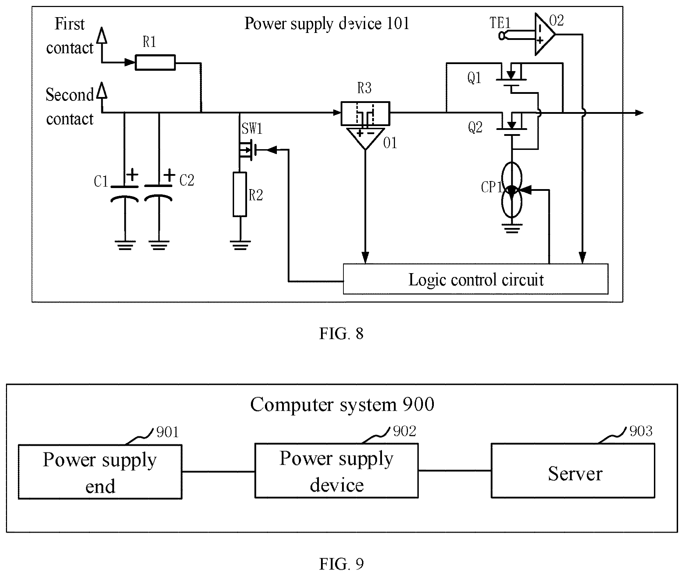

In some specific embodiments, the circuit structure of the power supply device 101 may be as shown in FIG. 8. Reference is made to a first contact 201, a second contact 202, a current limiting circuit 203, a filter energy storage circuit 204, a bleeder circuit, a current detection circuit 701, a current switching circuit 702, a logic control circuit 703 and a temperature detection circuit in FIGs. 2, 6 and 7.

Specifically, the current limiting circuit 203 includes a resistor R1. The filter energy storage circuit 204 may include filter capacitors C1 and C2, and the quantity of the filter capacitors may be determined according to requirements. The bleeder circuit may include a switch SW1 and a resistor R2. The current detection circuit 701 may include a current detection unit (a resistor R3 and an operational amplifier O1). The current switching circuit 702 may include field effect transistors Q1 and Q2 and a charge pump CP1. The temperature detection circuit may include a temperature sensor TE1 and an operational amplifier O2.

The first contact is connected to one end of a resistor R1 of the current limiting circuit, the other end of R1 is connected to a first end (a positive terminal) of the filter capacitors C1 and C2, and a second contact is connected to a first end (a positive terminal) of the filter capacitor C1 and a first end (a positive terminal) of the filter capacitor C2. The negative terminal of the filter capacitor C1 and the filter capacitor C2 are both grounded. The filter capacitor C1 and the filter capacitor C2 are connected in parallel to the current transmission circuit. The first end of C1 and the first end of C2 are both connected to the first end of the switch SW1 of the bleeder circuit. The other end of the switch SW1 is connected to the logic control circuit. The other end of the switch SW1 is connected to a resistor R2 which is connected to ground, and the resistor R2 is used to limit the magnitude of the current in the bleed circuit. The current transmission circuit includes a current detection circuit and a current switching circuit. Herein, the resistor R3 in the current detection circuit is connected to the operational amplifier O1, and the other end of the operational amplifier O1 is connected to the logic control circuit. An input end of the resistor R3 is connected to the filter capacitor C2 and a first end of the filter capacitor C2. An output end of the resistor R3 is connected to the current switching circuit. Specifically, the output end of the resistor R3 is connected to the drain terminal of the field effect transistors Q1 and Q2 of the current switching circuit. The source terminal of the field effect transistors Q1 and Q2 are connected to the power interface of the server. The field effect transistor Q1 and the field effect transistor Q2 are connected in parallel, and the drain terminal segments of the field effect transistor Q1 and the field effect transistor Q2 are connected to a first end of the charge pump CP1. A second end of the charge pump CP1 is connected to the logic control circuit. A third end of the charge pump CP1 is connected to ground. The temperature sensor TE1 of the temperature detection circuit is connected to the operational amplifier O2, and the other end of the operational amplifier O2 is connected to the logic control circuit.

In some embodiments, the power supply device 101 includes a power board, and components of the current limiting circuit 203, the filter energy storage circuit 204 and the current transmission circuit 205 are arranged on the power board. The first contact 201 is connected to the current limiting circuit 203 and the current transmission circuit 205 by means of welding or cable connection. The second contact 202 is connected to the current transmission circuit 205 by means of welding or cable connection.

In some embodiments, the power board includes a copper foil for conducting electrical current between components of the circuits on the power board. The power board also includes a gold finger contact, and the current transmission circuit 205 is connected to a power interface of the server 102 via the gold finger contact to supply power to the server 102.

It will be understood by those skilled in the art that the structures shown in FIGs. 2, 6, and 7 are merely block diagrams of some of the configurations associated with the embodiments of the present disclosure, and do not constitute limitations on the power supply device to which the embodiments of the present disclosure are applied. A particular power supply device may include more or less components than those shown in the drawings, or it may combine some components, or may have different arrangements of components.

In a second aspect, an embodiment of the present disclosure provides a computer system. As shown in FIG. 9, a computer system 900 may include a power supply end 901, a server 903 and a power supply device 902.

The power supply end 901 is used to provide power, and the power supply device 902 is used to electrically connect the power supply end 901 and a power interface of the server 903 to supply power to the server 903. The power supply device 902 is the power supply device disclosed in any one of the embodiments of the first aspect.

In some embodiments, the conductive interface of the power supply end 901 is a copper bar for transmitting direct current. The power interface of the server 903 is a power supply interface. The power supply device 902 is used to connect the copper bar and the power supply interface connection, so as to supply power to the server 903.

By electrically connecting the power supply device 902 with the server 903 and the power supply end 901, in the process of inserting the power supply device 902 into the power supply end 901, a first contact contacts the power supply end 901 before a second contact, and the first contact contacting the power supply end 901 transmits the current to the position of the second contact, thereby raising the voltage of the second contact in advance. As the power supply device 902 continues to be inserted, the voltage value at the position of the second contact approaches or is equal to the positive voltage value of the power supply end 901. Therefore, at the moment when the second contact is inserted into the power supply end 901 to conduct a circuit, there will be no spark due to the momentary large voltage difference, which improves the safety and reliability of the power supply to the server 903.

At the same time, the power supply device 902 may use a centralized power supply mode to supply power to the server 903, which may improve the power conversion efficiency and also enhance the flexibility of deployment of the server 903 without modifying the interface of the server 903.

In some embodiments, the computer system includes a plurality of power supply devices for connecting the server and the power supply end to form a parallel circuit for supplying power to the server.

The operating power of the server is greater than the rated power of any one power supply device; and the total rated power of the plurality of power supply devices is greater than the operating power of the server.

As the computing performance of the server increases, the operating power of the server also increases. When the operating power of the server is greater than the rated power of one power supply device, it is necessary to configure a plurality of power supply devices for the server, so that the total rated power of the plurality of power supply devices is greater than the operating power of the server, so as to ensure the normal operation of the server.

In some embodiments, the plurality of power supply devices includes a redundant power supply device.

In the related art, when a PSU power supply mode is adopted for a server, if the server needs to supply power to the server using N PSU power supplies, since each PSU power supply needs to perform an alternating current-to-direct current operation on the accessed alternating current, and each PSU power supply has the capability of raising an output voltage and current sharing, the failure of any PSU power supply will affect the normal operation of the server. Therefore, in order to ensure the reliability of the PSU power supply, N redundant PSU power supplies generally need to be configured, and thus the power supply cost is high.

However, in the present embodiment, since the power supply device supplies power using centralized power supply, it does not have the capability of actively raising the output voltage, and only one redundant power supply device be configured. When any one of the power supply devices fails, the redundant power supply device may replace the operation thereof to ensure the stable operation of the server.

In some embodiments, any two of the plurality of power supply devices have a same size and circuit design.

In some specific embodiments, the size and electrical specifications of the first contact of any two of the plurality of power supply devices are the same, the size and electrical specifications of the second contact of any two of the plurality of power supply devices are the same, and the circuit components and circuit designs in the power board of any two of the plurality of power supply devices are the same.

Therefore, in the development and design process of the power supply device, only one size and circuit design of the power supply device needs to be developed, which may reduce the development cost. At the same time, as the server connection of multiple power supply devices is completely consistent, it may also facilitate blind plug-in.

In some embodiments, the power supply device may also be designed differently according to the difference of location between the power interfaces of the servers and the difference of heat dissipation environment to improve the performance and operation stability of the power supply device.

In some embodiments, the current rating of the current limiting circuit of each of the plurality of power supply devices is proportional to the quantity of power supply devices.

Although the first contacts of any two of the plurality of power supply devices are of the same length. However, in an actual product, there may be small differences in the installation gap between different power supply devices. This resulting in that when a server connected with a plurality of power supply devices is plugged into a power supply end, the contact between a first contact and a conductive interface of the power supply end has a sequential difference. Since parallel circuits are formed between various power supply devices to supply power to the server, the first contact which first contacts the conductive interface of the power supply end needs to supply the current for the filter energy storage circuits in all the plurality of power supply devices. Therefore, the rated current of the current limiting circuit of each power supply device in a plurality of power supply devices needs to be able to load the total capacitance value of the plurality of filter and energy storage circuits, that is to say, the rated current of the current limiting circuit is required to be proportional to the quantity of power supply devices.

In some specific embodiments, when the server is connected to one power supply device, the rated current output by the current limiting circuit of the power supply device is 3A. When the server is connected to five power supply devices, the rated current of the current limiting circuit of each power supply device is 15A.

In some embodiments, the power rating of the current limiting resistor of the current limiting circuit of each of the plurality of power supply devices is proportional to the quantity of power supply devices.

In a case where one first contact in the plurality of power supply devices makes contact with a conductive interface of a power supply end prior to other first contacts, the actual current in the current limiting circuit corresponding to this first contact is forced to increase, thereby resulting in the current limiting resistor being burnt out.

In some embodiments, the enable signal of the bleeder circuit of each of the plurality of power supply devices is connected at the first contact on the power board, respectively.

In some embodiments, the server includes a control circuit, and each of the plurality of power supply devices is connected to the control circuit of the server, enabling the control circuit to obtain circuit parameters of each of the plurality of power supply devices, wherein the circuit parameters include current value and/or temperature data for the current transmission circuit.

In some embodiments, the current detection circuit of each of the plurality of power supply devices may be connected in parallel via a pin of a gold finger connector of the server.

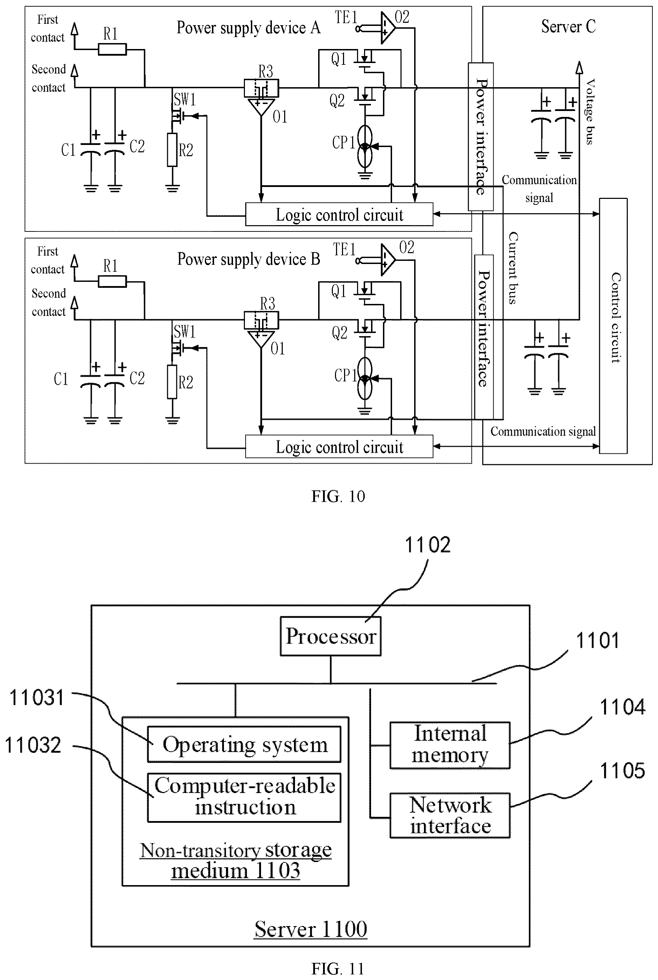

In some specific embodiments, a specific structure of a plurality of power supply devices electrically connected to a server is shown in FIG. 10. The figure illustrates an example of two power supply devices (A, B) being electrically connected to a server C.

The circuit structures of the power supply device A and the power supply device B are consistent. The power supply device A and the power supply device B both include a first contact and a second contact, a current limiting circuit resistor R1, a filter capacitor C1 and a filter capacitor C2, a switch SW1 of a bleeder circuit, a resistor R2 of the current bleeder circuit, a resistor R3 in a current detection circuit, an operational amplifier O1 in the current detection circuit, a field effect transistor Q1 in a current switching circuit, a field effect transistor Q2 in the current switching circuit, a charge pump CP1 in the current switching circuit and a temperature sensor TE1, and an operational amplifier O2 in the temperature detection circuit.

Since the circuit component design and the component connection relationship of the power supply device A and B are the same, taking the power supply device A as an example for explanation, in the power supply device A, the first contact is connected to one end of a resistor R1 of the current limiting circuit, the other end of R1 is connected to a first end (a positive terminal) of the filter capacitors C1 and C2, and a second contact is connected to a first end (a positive terminal) of the filter capacitor C1 and a first end (a positive terminal) of the filter capacitor C2. The negative terminal of the filter capacitor C1 and the filter capacitor C2 are both grounded. The filter capacitors C1 and C2 are connected in parallel to the current transmission circuit. The first ends of C1 and C2 are both connected to the first end of the switch SW1 of the bleeder circuit. The other end of the switch SW1 is connected to the logic control circuit. The other end of the switch SW1 is connected to a resistor R2 which is connected to ground, and the resistor R2 is used to limit the magnitude of the current in the bleed circuit. The current transmission circuit includes a current detection circuit and a current switching circuit. A resistor R3 in the current detection circuit is connected to an operational amplifier O1, and the other end of the operational amplifier O1 is connected to a logic control circuit. The operational amplifier O1 is also connected to a power interface of the server. An input end of the resistor R3 is connected to a filter capacitor C2 and a first end of the filter capacitor C2, and an output end of the resistor R3 is connected to a current switching circuit. Specifically, the output end of the resistor R3 is connected to the drain terminal of the field effect transistors Q1 and Q2 of the current switching circuit. The source terminal of the field effect transistors Q1 and Q2 are connected to the power interface of the server. The field effect transistor Q1 and the field effect transistor Q2 are connected in parallel, and the drain terminal segments of the field effect transistor Q1 and the field effect transistor Q2 are connected to a first end of the charge pump CP1. A second end of the charge pump CP1 is connected to the logic control circuit. A third end of the charge pump CP1 is connected to ground. The temperature sensor TE1 of the temperature detection circuit is connected to the operational amplifier O2, and the other end of the operational amplifier O2 is connected to the logic control circuit.

The circuit structure in the server C shown in FIG. 10 may be a circuit structure of a main board of the server. The server C includes a plurality of sub-servers, and each of the sub-servers includes a filter capacitor. A current transmission circuit of the power supply devices A and B are electrically connected to a power interface of each sub-server. The power interface may be a gold finger connector of the server. Accordingly, the current transmission circuit is electrically connected to the power interface of the server may be connected to a pin of the gold finger connector to form a parallel circuit for supplying power to the server. The power supply devices A and B are respectively connected to pins of different gold finger connectors. The power interface of each server is also respectively connected to a filter capacitor of each server. A voltage bus is formed in the server C. The control circuit of the server C is connected to the logic control circuits of the power supply devices A and B.

The current transmission path of the power supply device is connected to the filter capacitor and the voltage bus of the server, and the current transmission paths of a plurality of power supply devices are connected in parallel. In addition, the logic control circuit of the power supply device is connected to the control circuit in the server, enablingto transmit communication signals between each other.

In some specific embodiments, the current signal collected by the current detection circuit may be taken as a siginal level. When a plurality of power supply devices are connected in parallel, the current flow signal constitutes a current bus. The signal level of the current bus is actually an average value of the currents of a plurality of power supply devices. The current detection circuit or the logic control circuit of any one of the power supply devices may determine whether the current of the current transmission circuit of the power supply device exceeds the average value according to the bus level, and identifying any current abnormality.

In some embodiments, the control circuit of the server is configured for controlling the current switching components of all the plurality of power supply devices to shut off the current transmission when the current values of the current transmission circuits of all the plurality of power supply devices in the system are all greater than the preset current threshold, or the temperature data are all greater than the preset temperature threshold.

A control circuit of the server is connected to a logic control circuit of the power supply device, and may monitor current values and temperature data of current transmission circuits of each power supply device. When the current values of all the plurality of power supply devices are greater than a preset current threshold or the temperature values are greater than a preset temperature threshold, the current switching components of all the plurality of power supply devices are controlled to shut off the current transmission of the current transmission circuits.

Herein, the preset current threshold may be 1.5 times the current value of the current bus of the server, and the preset temperature threshold may be 105 degrees centigrade.

In the above embodiments, when it is described that one circuit is connected to another circuit, or that an output end of one circuit is connected to an input terminal of another circuit, it indicates that the two circuits may be either directly or indirectly connected, that is, there may also be other circuits or intervening elements between the two circuits. In any event, there is a signal flow relationship between the two circuits.

In a third aspect, embodiments of the present disclosure provide a method of installing a server, which may include the steps of:
electrically connecting the power supply device with a power interface of the server, and
inserting a first contact of the power supply device into the power supply end at a preset speed.

Herein, the power supply device is the power supply device disclosed in any of the embodiments of the first aspect, and the power interface of the server is a power interface of the server which may be connected to a PSU power supply.

The preset speed is less than the quotient of the product of the difference between the lengths of the first contact and the second contact, the capacitance value of the filter capacitor and the supply voltage value of the server, and the current value outputted by the current limiting circuit.

By inserting a power supply device electrically connected to a server into a power supply end at a preset speed, in the process of inserting the power supply device into the power supply end, a first contact contacts the power supply end before a second contact, and the first contact contacting the power supply end transmits the current to the position of the second contact to raise the voltage of the second contact in advance. As the power supply device continues to be inserted, the voltage value at the position of the second contact approaches or is equal to the positive voltage value of the power supply end. Therefore, at the moment when the second contact is inserted into the power supply end to conduct a circuit, there is no spark due to the momentary large voltage difference, which improves the safety and reliability of the power supply to the server.

In some specific embodiments, when a server is electrically connected to a plurality of power supply devices, the electrically connecting the power supply device to a power interface of the server includes the step of electrically connecting a plurality of power supply devices to a plurality of target power interfaces respectively, wherein the target power interfaces are power interfaces with the power supply path length of the server motherboard being within a preset range.

Exemplarily, when the server is electrically connected to the N power supply devices, the N power interfaces of the power interfaces of the server with the minimum difference in the power supply paths are selected for connection with the power supply devices to ensure the minimum difference in the impedance of the N power supply paths.

In some embodiments, the power supply end includes a conductive interface. Inserting a first contact of the power supply device into the power supply end at a preset speed includes inserting a first contact of the power supply device into the conductive interface at a preset speed. In particular, the conductive interface may be a copper bar.

By controlling the advancing speed at which the first contact is inserted into the conductive interface of the power supply end, it may be ensured that, after the insertion of the first contact is completed, when the second contact is inserted into the conductive interface of the power supply end, the voltage value on the current transmission circuit connected to the second contact approaches or is equal to the positive electrode voltage value of the power supply end, thereby avoiding the occurrence of an electric spark.

In some embodiments, the server installation method further includes controlling the server to start after the second contact of the power supply device is inserted into the power supply end.

In the related art, starting the server when the power supply device is not fully inserted into the conductive interface of the power supply end may cause the current to be supplied into the server at the moment when the power supply device contacts the power supply end. At this moment, the current is unstable, posing a security risk in the operation of the server.

In the embodiment of the present disclosure, the starting of the server needs to be performed after the second contact of the power supply device is inserted into the power supply end. That is to say, after the power supply device is completely inserted into the conductive interface, the server is started. At this moment, the filter capacitor in the power supply device has been fully charged, and the current and voltage transmitted via the power supply device are stable, which may improve the safety and reliability of the operation of the server.

In some embodiments, as a computer device, the server 1100 may include a processor 1102, a non-transitory storage medium 1103, an internal memory 1104, and a network interface 1105, all connected by a system bus 1101, as shown in FIG. 11. The processor 1102 is configured for providing computing and control capabilities. The non-transitory storage medium 1103 and the internal memory 1104 are memories of a server 1100. The non-transitory storage medium 1103 stores an operating system 11031 and computer-readable instructions 11032. The internal memory 1104 provides an environment for operation of the operating system 11031 and the computer-readable instructions 11032 in the non-transitory storage medium 1103. The network interface 1105 is adapted to communicate with an external terminal or other server via a network connection. In other embodiments, the server 1100 may include more or fewer components, or combine certain components, or have a different arrangement of components.

The technical features of the above-mentioned embodiments may be combined in any combination. In order to make the description concise, not all the possible combinations of the technical features in the above-mentioned embodiments are described. However, as long as there is no contradiction between the combinations of the technical features, they should be considered within the scope of the present disclosure.

The foregoing examples, which represent only a few embodiments of the present disclosure, are described in more detail, but are not to be construed as limiting the scope of the present disclosure. It should be noted that several variations and modifications may be made by one skilled in the art without departing from the inventive concept of the present disclosure, which is within the scope of the present disclosure. Accordingly, the protection sought herein is as set forth in the claims below.

## Claims

1. A power supply device, wherein the power supply device comprises a first contact and a second contact;
the first contact is configured for electrically connecting a conductive interface of a power supply end and the second contact;
the second contact is configured for electrically connecting a conductive interface of the power supply end and a power interface of a server;
wherein a length of the first contact is greater than a length of the second contact, so that, during insertion of the power supply device into the power supply end, the first contact makes contact with the conductive interface first to raise a voltage of the second contact in advance, and then the second contact starts to connect with the conductive interface to supply power to the server.

2. The device according to claim 1, wherein the first contact is elastically telescoping, and a length of a fully extended first contact is greater than the length of the second contact in a telescoping direction, so that the first contact is in an elastically retracted state after being abutted against the conductive interface during the insertion of the power supply device into the power supply end.

3. The device according to claim 2, wherein the first contact and the second contact are arranged in parallel in the telescoping direction.

4. The device according to any one of claims 1 to 3, wherein the power supply device further comprises a current limiting circuit, and the current limiting circuit is connected between the first contact and the second contact.

5. The device according to 4, wherein the power supply device further comprises a filter energy storage circuit connected to the second contact, the filter energy storage circuit comprises a filter capacitor for storing and filtering a current transmitted to the second contact via the current limiting circuit.

6. The device according to 5, wherein the power supply device further comprises a bleeder circuit and a logic control circuit;
the bleeder circuit comprises a bleeder switch, and three ends of the bleeder switch are respectively connected to the second contact, the logic control circuit and a ground end; and
the logic control circuit is configured for controlling a switching state of the bleeder switch, and current in the filter capacitor is discharged when the bleeder switch is turned on.

7. The device according to claim 5, wherein a length difference between the first contact and the second contact is a quotient of a product of a preset plugging speed of the power supply device and a value of current outputted by the current limiting circuit and a product of a capacitance value of the filter capacitor and a supply voltage value of the server.

8. The device according to claim 7, wherein
the capacitance value of the filter capacitor ranges from 5,000 µF to 10,000 µF;
the supply voltage value of the server is 12 V or 54 V;
the preset plugging speed ranges from 0.01 m/s to 0.5 m/s; and
the value of the current outputted by the current limiting circuit ranges from 2 A to 10 A.

9. The device according to claim 7 or 8, wherein the length difference ranges from 0.01 m to 0.3 m.

10. The device according to any one of claims 1 to 9, wherein each of the first contact and the second contact comprises a metal plate; and the metal plate of the first contact and the metal plate of the second contact are used for being connected to the conductive interface to enable electrical conduction from the power supply end.

11. The device according to any one of claims 1 to 10, wherein a load current value of the first contact is less than a load current value of the second contact; and the load current value of the second contact is determined by a power value of the server and a supply voltage value of the server.

12. The device according to any one of claims 1 to 11, wherein the power supply device further comprises a current transmission circuit, the current transmission circuit is connected between the second contact and the power interface of the server;
the current transmission circuit comprises a current detection circuit and a current switching circuit; the power supply device also comprises a logic control circuit;
the current detection circuit comprises a current detection component, the current detection component is connected to the logic control circuit, to detect a current value of the current transmission circuit and transmit the current value to the logic control circuit;
the current switching circuit comprises a current switching component, the current switching component is connected to the logic control circuit; and
the logic control circuit is configured for controlling a switching state of the current switching component according to the current value of the current transmission circuit to change a current transmission state of the current transmission circuit and the power interface of the server.

13. The device according to claim 12, wherein the current switching component comprises a control switch and a field effect transistor; a gate terminal of the field effect transistor is connected to the control switch; and a drain terminal and a source terminal of the field effect transistor are connected to both ends of the current transmission circuit, respectively, to adjust a current flowing state of the current transmission circuit according to a gate voltage generated by the control switch.

14. The device according to claim 13, wherein the logic control circuit is further configured for:
in response to the current value of the current transmission circuit being greater than a second current threshold that is preset and less than a first current threshold that is preset, reducing the gate voltage generated by the control switch to reduce the current value of the current transmission circuit until the current value of the current transmission circuit is less than the second current threshold; and
turning off the control switch to shut off current transmission of the current transmission circuit in response to the current value of the current transmission circuit being greater than the first current threshold;
wherein the first current threshold is greater than the second current threshold, and the first current threshold and the second current threshold have a multiple relationship with a preset server current threshold.

15. The device according to any one of claims 12 to 14, wherein the power supply device further comprises a temperature detection circuit for detecting temperature of the current switching component;
the temperature detection circuit is connected to the logic control circuit, and the logic control circuit is further configured for, in response to temperature data transmitted by the temperature detection circuit being greater than a preset temperature threshold, turning off the current switching component to shut off current transmission of the current transmission circuit.

16. A computer system, wherein the system comprises the power supply end, the server and the power supply device according to any one of claims 1 to 15; and the power supply device is configured for electrically connecting the power supply end and a power interface of the server to supply power to the server.

17. The system according to claim 16, wherein
the conductive interface of the power supply end is a copper bar for transmitting direct current;
the power interface of the server is a power supply interface; and
the power supply device is configured for connecting the copper bar and the power supply interface to supply power to the server.

18. The system according to claim 16 or 17, wherein
the system comprises a plurality of power supply devices; and
the plurality of power supply devices are configured for connecting the server and the power supply end to form a parallel circuit for supplying power to the server; wherein operating power of the server is greater than the rated power of any one of the plurality of power supply devices; and the total rated power of the plurality of power supply devices is greater than the operating power of the server.

19. The system according to claim 18, wherein the plurality of power supply devices comprises a redundant power supply device.

20. The system according to claim 18 or 19, wherein any two of the plurality of power supply devices have a same size and circuit design.

21. The system according to any one of claims 18 to 20, wherein rated current of a current limiting circuit of each of the plurality of power supply devices is proportional to a quantity of the plurality of power supply devices.

22. The system according to any one of claims 18 to 21, wherein the server comprises a control circuit, and each of the plurality of power supply devices is connected to the control circuit of the server to enable the control circuit of the server to obtain circuit parameters of each of the plurality of power supply devices, wherein the circuit parameters comprise current value and/or temperature data of the current transmission circuit.

23. The system according to claim 22, wherein the control circuit of the server is configured for:
in response to current values of the current transmission circuits of all the plurality of power supply devices in the system being greater than a preset current threshold, controlling current switching components of all the plurality of power supply devices to shut off current transmission; or
in response to temperature data of all the plurality of power supply devices in the system being higher than a preset temperature threshold, controlling the current switching components of all the plurality of power supply devices to shut off the current transmission.
